# EUROPEAN PATENT SPECIFICATION

(11) **EP 3 958 296 B1**
(45) Date of publication and mention of the grant of the patent: **28.02.2024**
(21) Application number: 21792686.4
(22) Date of filing: 21.04.2021
(51) Int. Cl.: G05B 23/02, H01L 21/677

(54) **FAULT MONITORING SYSTEM AND METHOD USED DURING SEMICONDUCTOR MANUFACTURING PROCESS**
FEHLERÜBERWACHUNGSSYSTEM UND VERFAHREN ZUR VERWENDUNG IN EINEM HALBLEITERHERSTELLUNGSVERFAHREN
SYSTÈME ET PROCÉDÉ DE SURVEILLANCE D'ANOMALIES UTILISÉS PENDANT UN PROCESSUS DE FABRICATION DE SEMI-CONDUCTEURS

(30) Priority: 21.04.2020 CN 202010316832
(43) Date of publication of application: 23.02.2022
(73) Proprietor: Changxin Memory Technologies, Inc., Hefei, Anhui 230000 (CN)
(72) Inventor: LI, Huancheng, Hefei, Anhui 230000 (CN)
(74) Representative: Lavoix
(86) International application number: PCT/CN2021/088629
(87) International publication number: WO 2021/213425

(56) References cited:
- CN-A- 101 151 197
- CN-A- 104 181 812
- CN-A- 109 755 165
- CN-A- 110 875 222
- CN-A- 110 957 245
- US-A1- 2005 075 748
- US-A1- 2009 062 954
- US-A1- 2009 276 082

## Description

### CROSS-REFERENCE TO RELATED APPLICATION

This application claims priority to Chinese patent application No. 202010316832.X, filed on April 21, 2020 and entitled "Fault Monitoring System and Method for Semiconductor Manufacturing Process".

### TECHNICAL FIELD

The disclosure relates to the technical field of semiconductor manufacturing, and more particularly, to a fault monitoring system and method for a semiconductor manufacturing process.

### BACKGROUND

In a manufacturing process of a semiconductor device, a Front Opening Unified Pod (FOUP) is generally used to protect, convey, and store a wafer, to avoid the contamination of the wafer by tiny dust in the external environment during the conveyance of the wafer between each piece of production Equipment (EQP), which may affect the yield rate. Currently, an Automated Material Handling System (AMHS) is generally used to implement the conveyance to improve the production efficiency and the safety.

A current conveying process mainly includes following operations. When a FOUP including a wafer is to be handled, a Manufacturing Execution System (MES)

sends a handling request to the AMHS. The AMHS assigns its own Overhead Hoist Transfer (OHT) to handle the specified FOUP to the destination EQP, conveys the FOUP to a position above the EQP (semiconductor production EQP), and places the FOUP at a Load Port of the EQP. The Load Port reads and reports a FOUP Identity document (ID) to an EQP Automation Program (EAP). The EAP reports the goods arrival at EQP as well as the FOUP ID read by the EQP to a Tool Control System (TCS). The TCS generates a goods arrival at EQP record and a FOUP ID reading record according to the reported EQP and the FOUP ID read by the EQP, and sends them to the MES, such that the MES updates a goods arrival at EQP state to a database according to the received goods arrival at EQP record and FOUP ID reading record, and then performs the subsequent production flows.

However, after the MES sends a handling task to the AMHS and the FOUP is handled to the EQP by the OHT, there may often be such a problem that the EQP does not read the FOUP ID and report the FOUP ID to the TCS and the EAP, resulting in no operation after goods arrival at EQP, which seriously affects the production efficiency. Patent application US2005/075748A1 discloses a computer Integrated Manufacturing (CIM) systems used in automated IC fabrication facilities, in which an automated issue resolution management (ISRM) subsystem directs attempts to automatically resolve issues including error conditions relating to automated manufacturing facility and checks if the reported issue is a recognized issue for which automatic resolution is available.

### SUMMARY

A method according to the invention is defined by the wording of claim 1.

An apparatus according to the invention is defined by the wording of claim 2.

Details of one or more embodiments of the disclosure will be put forward in the following accompanying drawings and descriptions. Other features, objectives, and advantages of the disclosure will become clearer in the description, the accompanying drawings, and the claims.

### BRIEF DESCRIPTION OF THE DRAWINGS

In order to describe and illustrate the embodiments of the disclosure better, references can be made to one or more accompanying drawings.
FIG. 1 is a flowchart of a method for monitoring a fault in a semiconductor manufacturing process according to an embodiment of the disclosure.
FIG. 2 is a flowchart of another method for monitoring a fault in a semiconductor manufacturing process according to an embodiment of the disclosure.
FIG. 3 is a schematic diagram of an electrical structure of a system for monitoring a fault in a semiconductor manufacturing process according to the disclosure.
FIG. 4 is a schematic diagram of another electrical structure of a system for monitoring a fault in a semiconductor manufacturing process according to the disclosure.
FIG. 5 is a schematic diagram of an interactive relationship between a system for monitoring a fault in a semiconductor manufacturing process and another system according to the disclosure.

### DETAILED DESCRIPTION

In order to make the objectives, features, and advantages of the disclosure clearer and easier to understand, specific implementations of the disclosure will be described below in detail in conjunction with the accompanying drawings. Many specific details are described in the following descriptions to facilitate a full understanding of the disclosure.

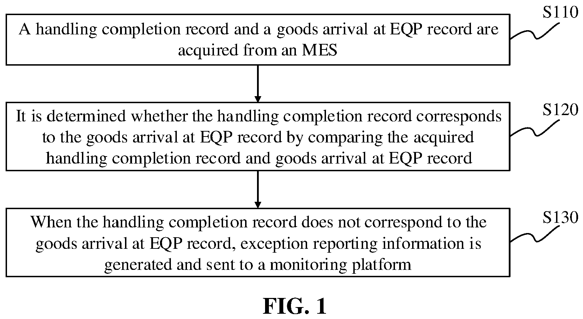

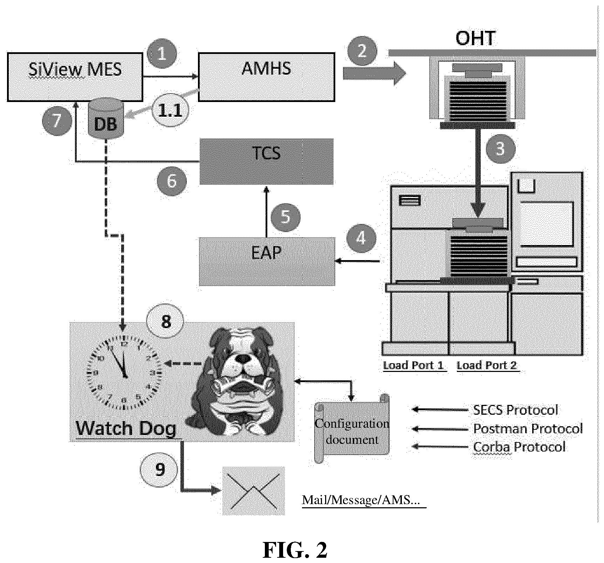

Referring to FIG. 1 and FIG. 2, an embodiment of the disclosure provides a method for monitoring a fault in a semiconductor manufacturing process. The method includes steps S110 to S130.

In S110, a handling completion record and a goods arrival at EQP record are acquired from an MES.

In the embodiment, the handling completion record is generated and reported to the MES after an AMHS performs a corresponding handling operation on a material responsive to a handling request from the MES. In general, the handling completion record includes at least an ID of destination EQP and an ID of the material in successful handling. For an actual case that a FOUP is used to protect and convey a wafer, the ID of the material may specifically be a FOUP ID. Furthermore, an actual handling process further includes handling the FOUP to a Load Port of the destination EQP. Generally, each piece of EQP includes multiple corresponding Load Ports. In another non claimed embodiment, the handling completion record may further include a Load Port ID of the destination EQP.

The destination EQP reports the goods arrival at EQP record to a TCS after receiving and reading the handled material, and then the TCS reports the goods arrival at EQP record to the MES. The goods arrival at EQP record includes at least an ID of the material read by the EQP and an ID of the EQP. In the embodiment, the goods arrival at EQP record includes the EQP ID and a FOUP ID reported by the EQP. In another non claimed embodiment, the goods arrival at EQP record may further include a specific Load Port ID of the destination EQP.

In a specific manufacturing process, when a FOUP including a wafer is to be handled, the MES sends a handling task to the AMHS. The AMHS assigns its own OHT to handle the specified FOUP to the destination EQP, conveys the FOUP to a position above the EQP (semiconductor production EQP), places the FOUP at a Load Port of the EQP, and then generates a handling completion record after successful handling, the handling completion record includes a destination EQP ID, a Load Port ID, and a FOUP ID. The Load Port reads and reports the FOUP ID to an EAP. The EAP reports the EQP that performs a reporting operation and the FOUP ID read by the EQP to the TCS. The TCS generates a goods arrival at EQP record according to the reported EQP ID and the FOUP ID read by the EQP, and sends the goods arrival at EQP record to the MES, such that the MES updates a goods arrival at EQP state to a database according to the received goods arrival at EQP record and stores the goods arrival at EQP record.

It should be understood that the EQP ID may be an EQP number, an EQP type, or other information of the EQP. In the embodiment, the EQP number is used as the EQP ID, and thus the EQP ID may be named according to a process characteristic. However, each piece of EQP corresponds to only one EQP ID for the convenience of management. In addition, the method for monitoring the fault may be implemented by the monitoring program "watchdog". In some other non claimed embodiments, the handling completion record and the goods arrival at EQP record may further include some other information, such as the material state information and the handling time information. Herein the material state information is configured to represent a current production state of the material, for example, the material is currently to be processed or under processing.

In S 120, it is determined whether the handling completion record corresponds to the goods arrival at EQP record by comparing the acquired handling completion record and goods arrival at EQP record.

In the embodiment, the handling completion record and the goods arrival at EQP record are compared. When the ID of the destination EQP involved in successful handling in the handling completion record is the same as the EQP ID in the goods arrival at EQP record, and the ID of the handled material is the same as the ID of the material read by the EQP, it is determined that the handling completion record corresponds to the goods arrival at EQP record. Otherwise, it is determined that the compared handling completion record does not correspond to the goods arrival at EQP record.

Specifically, determining whether the handling completion record corresponds to the goods arrival at EQP record one by one by comparing the acquired handling completion record and goods arrival at EQP record is mainly determining whether there is a respective matched goods arrival at EQP record for each handling completion record according to the information of FOUPs in the handling completion record and the goods arrival at EQP record, the information of the FOUP includes the specific position information of the FOUPs, the production state information of the FOUPs, and the FOUP IDs. When there is no goods arrival at EQP record matched with one of the handling completion records can be found, it is determined that the EQP corresponding to the handling completion record completes the handling but has not updated the information of the FOUP, that is, the EQP has not performed a reading operation currently.

In S130, when the handling completion record does not correspond to the goods arrival at EQP record, exception reporting information is generated and sent to a monitoring platform.

In the method for monitoring the fault provided in the disclosure, the handling completion record and the goods arrival at EQP record are compared, and when the handling completion record does not correspond to the goods arrival at EQP record, it is determined that an exception occurs to the manufacturing process, and the exception reporting information is generated and sent to the monitoring platform, so that no operation after goods arrival at EQP may be monitored automatically to find the problem of no reading operation after the goods arrives at the EQP as soon as possible, thereby the production efficiency can be ensured.

In the embodiment, the operation that the handling completion record and the goods arrival at EQP record are acquired from the MES includes the following operation.

The handling completion record is acquired from a first submodule of a storage module of the MES, and the goods arrival at EQP record is acquired from a second submodule of the storage module of the MES.

It should be understood that, in the embodiment, the storage module of the MES includes the first submodule and the second submodule, the first submodule and the second submodule are configured to store the handling completion record and the goods arrival at EQP record respectively. The handling completion record and the goods arrival at EQP record are stored and acquired separately, so that the data may be easily read and compared, which facilitate speeding up the processing process.

Due to a time difference between procedures, the handling completion record is updated earlier than the goods arrival at EQP record. Therefore, in an embodiment, acquiring the handling completion record and the goods arrival at EQP record from the MES further includes the following operations.

The triggering information sent by the MES is received. Herein the triggering information is generated by the MES after the MES receives the handling completion record.

The handling completion record is acquired from the MES according to the triggering information, and a first timing is started.

When the duration of the first timing reaches a first preset time interval, the goods arrival at EQP record is acquired from the MES.

In the embodiment, the triggering information is generated by the MES after updating the handling completion record to trigger "watchdog" to be started and acquire the handling completion record from the MES. Meanwhile, the first timing is performed, and when the duration of the first timing reaches the first preset time interval, the goods arrival at EQP record is acquired from the MES, thereby avoiding a false determination caused by untimely updating by the MES. It should be noted that the step of acquiring the handling completion record from the MES may be completed before the step of acquiring the goods arrival at EQP record, or may be executed at the same time with the step of acquiring the goods arrival at EQP record. No limits are made thereto in the embodiment.

In the embodiment, the operation that the exception reporting information is generated and sent to the monitoring platform when the handling completion record does not correspond to the goods arrival at EQP record includes the following operations.

When the handling completion record does not correspond to the goods arrival at EQP record, acquiring the goods arrival at EQP is retried after a second preset time interval, and it is determined whether the handling completion record corresponds to the goods arrival at EQP record until a number of retries reaches a preset number of retries.

When a result of the last determination shows that the handling completion record does not correspond to the goods arrival at EQP record, the exception reporting information is generated and sent to the monitoring platform.

In the embodiment, when the handling completion record does not correspond to the goods arrival at EQP record, the fault monitoring system determines the corresponding EQP that completes material handling but does not update a position or state of the material and the Load Port of the EQP, counts an "inconsistency" of the position or state of the material once, determines the count of the "inconsistency" as the number of retries, and determines whether the number of retries is less than the preset number of retries. If so, the second timing is performed, and when the duration of the second timing reaches the second preset time interval, the step of acquiring the goods arrival at EQP record from the second submodule of the storage module of the MES is re-executed. Otherwise, the exception reporting information is generated and sent to the monitoring platform.

After determining the corresponding EQP that completes handling but does not update the state and the Load Port of the EQP, considering that the time for the EQP to read and report the FOUP ID is much less than an interval between two handling tasks, the "watchdog" may, after it is determined that the handling completion record does not correspond to the goods arrival at EQP record one by one, repeatedly acquire the goods arrival at EQP record from the MES at a second preset time interval to confirm whether the problem of no operation after goods arrives at EQP exists as soon as possible and, when determining that the problem of no operation after goods arrival at EQP exists, notify a staff to solve the problem timely. In addition, acquiring the goods arrival at EQP record from the MES only at the second preset time interval may reduce a transmitted data volume and accelerate a determination process.

In the embodiment, a value of the second time interval ranges from 5 to 15 seconds. It should be understood that the value of the second time interval ranges from 5 to 15 seconds, so that the EQP has enough time to read and report the FOUP ID, a false determination caused by excessively short time and/or a relatively low reading speed of the EQP may be avoided. Furthermore, the problem of no operation after goods arrival at EQP cannot be found timely due to the excessively long time interval is also avoided. In the embodiment, the second time interval is preferably 8, 10, and 12 seconds.

In the embodiment, a value of the preset number of retries ranges from 3 to 8. It should be understood that the handling completion record is generated earlier than the goods arrival at EQP record, so the EQP that works normally may be in the process of reading or reporting the FOUP ID when the handling completion record is read. Thus it may not be determined whether there is no operation after goods arrival at EQP according to one comparison result. In the embodiment, after it is determined that the handling completion record does not correspond to the goods arrival at EQP record one by one, the goods arrival at EQP record may be acquired for many times according to the second time interval, and the "inconsistency" of the position or state of the material is counted continuously, i.e., when the number of retries reaches the preset number of retries, the exception reporting information is sent to avoid a false determination. In the embodiment, the preset number of retries is preferably set to 4, 5, and 6.

In a non claimed embodiment, the exception reporting information is sent to the monitoring platform by a mail, a message, or a notification of an Alarm Management System (AMS) to facilitate the staff at the monitoring platform to acquire the specific content of the exception reporting information and to quickly troubleshoot the fault. Furthermore, an alarming device may further be arranged at the monitoring platform, such as an alarm lamp flashing or an alarm horn beeping, to enable the staff at the monitoring platform to acquire the exception information timely. In the embodiment, the exception reporting information may include the EQP ID, the Load Port ID, and the FOUP ID, and in addition, may further include FOUP handling completion time and current state information of the material.

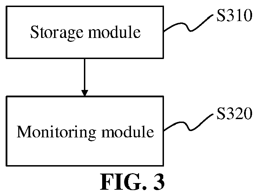

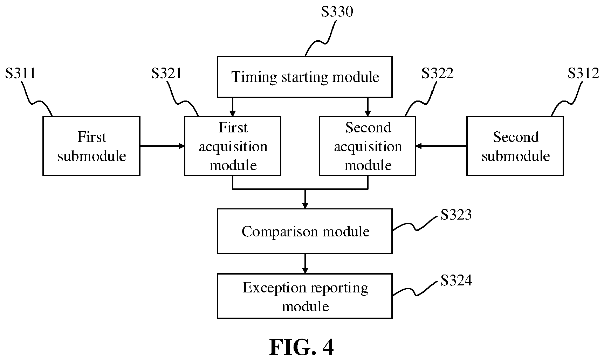

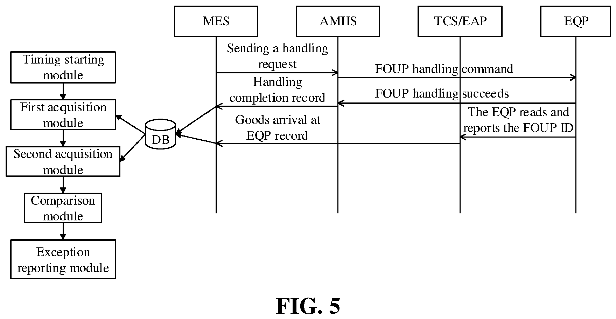

Referring to FIG. 3, FIG. 4, and FIG. 5, based on the same inventive concept, an embodiment of the disclosure further provides a system for monitoring the fault in a semiconductor manufacturing process. The system for monitoring the fault includes a storage module 310 and a monitoring module 320.

The storage module 310 is configured to store a handling completion record and a goods arrival at EQP record.

The monitoring module 320 is in communication connection with the storage module 310, and is configured to acquire the handling completion record and the goods arrival at EQP record from an MES, determine whether the handling completion record corresponds to the goods arrival at EQP record by comparing the acquired handling completion record and goods arrival at EQP record, and when the handling completion record does not correspond to the goods arrival at EQP record, generate exception reporting information and send the exception reporting information to a monitoring platform.

In the embodiment, the handling completion record is generated and reported to an MES after an AMHS performs a corresponding handling operation on a material responsive to a handling request from the MES. In general, the handling completion record includes at least an ID of destination EQP and an ID of the material in successful handling. For the AMHS that actually uses a FOUP to protect and convey a wafer, the ID of the material may specifically be a FOUP ID. Furthermore, an actual handling process further includes handling the FOUP to a Load Port of the destination EQP. Generally, each piece of EQP includes multiple corresponding Load Ports. In another non claimed embodiment, the handling completion record may further include a Load Port ID of the destination EQP.

The destination EQP reports the goods arrival at EQP record to a TCS after receiving and reading the handled material, and then the TCS reports the goods arrival at EQP record to the MES. The goods arrival at EQP record includes at least an ID of the material read by the EQP and an ID of the EQP. Specifically, the goods arrival at EQP record includes the EQP ID and a FOUP ID reported by the EQP. In another non claimed embodiment, the goods arrival at EQP record may further include a specific Load Port ID of the destination EQP.

In the specific manufacturing system, the storage module 310 is arranged in the MES. When a FOUP including a wafer is to be handled, the MES sends a handling task to the AMHS. The AMHS assigns its own OHT to handle the specified FOUP to the destination EQP, conveys the FOUP to a position above the EQP (semiconductor production EQP), places the FOUP at a Load Port of the EQP, and then generates a handling completion record after the successful handling, the handling completion record includes a destination EQP ID, a Load Port ID, and a FOUP ID. The Load Port reads and reports the FOUP ID to an EAP. The EAP reports the EQP that performs a reporting operation and the FOUP ID read by the EQP to the TCS. The TCS generates a goods arrival at EQP record according to the reported EQP and the FOUP ID read by the EQP, and sends the goods arrival at EQP record to the MES, such that the MES updates a goods arrival at EQP state to a database according to the received goods arrival at EQP record and stores the goods arrival at EQP record in the storage module 310.

It should be understood that the EQP ID may specifically be an EQP number, an EQP type, and other information of the EQP. In the embodiment, the EQP number is used as the EQP ID, and thus the EQP ID may be named according to a process characteristic. However, each piece of EQP corresponds to only one EQP ID for the convenience of management. In addition, the monitoring module 320 may be a monitoring program "watchdog". In the embodiment, the handling completion record and the goods arrival at EQP may further include some other information, such as material state information and handling time information. Herein the material state information is configured to represent a current production state of the material, for example, the material is currently to be processed or under processing.

In the embodiment, the storage module 310 includes a first submodule 311 and a second submodule 312. The first submodule 311 is configured to store the handling completion record. The second submodule 312 is configured to store the goods arrival at EQP record. It should be understood that the handling completion record and the goods arrival at EQP record are stored and acquired separately, so that the data may be easily read and compared, which facilitate speeding up the processing process.

In the embodiment, the monitoring module 320 includes a first acquisition module 321, a second acquisition module 322, a comparison module 323, and an exception reporting module 324.

The first acquisition module 321 is configured to acquire the handling completion record from the first submodule 311.

The second acquisition module 322 is configured to acquire the goods arrival at EQP record from the second submodule 312.

The comparison module 323 is configured to determine whether the handling completion record corresponds to the goods arrival at EQP record by comparing the acquired handling completion record and goods arrival at EQP record.

The exception reporting module 324 is configured to, when the handling completion record does not correspond to the goods arrival at EQP record, generate the exception reporting information and send the exception reporting information to the monitoring platform.

In the embodiment, the handling completion record and the goods arrival at EQP record are compared. When the ID of the destination EQP involved in successful handling in the handling completion record is the same as the EQP ID in the goods arrival at EQP record, and the ID of the handled material is the same as the ID of the material read by the EQP, it is determined that the handling completion record corresponds to the goods arrival at EQP record. Otherwise, it is determined that the compared handling completion record does not correspond to the goods arrival at EQP record.

Specifically, determining whether the handling completion record corresponds to the goods arrival at EQP record one by one by comparing the acquired handling completion record and goods arrival at EQP record is mainly determining whether there is a respective matched goods arrival at EQP record for each handling completion record according to the information of FOUPs in the handling completion record and the goods arrival at EQP record, the information of the FOUP includes the specific position information of the FOUPs, production state information of the FOUPs, and the FOUP IDs. When there is no goods arrival at EQP record matched with one of the handling completion record can be found, it is determined that the EQP corresponding to the handling completion record completes the handling but has not update the information of the FOUP, that is, the EQP has not performed a reading operation currently.

In the embodiment, the fault monitoring system further includes a timing starting module 330. The timing starting module 330 is configured to receive triggering information sent by the MES, trigger, according to the triggering information, the first acquisition module 321 to acquire the handling completion record, start a first timing, and when the duration of the first timing reaches a first preset time interval, trigger the second acquisition module 322 to acquire the goods arrival at EQP record.

In the embodiment, the triggering information is generated by the MES after updating the handling completion record to trigger "watchdog" to be started and acquire the handling completion record from the MES. In addition, since the handling completion record is generated earlier than the goods arrival at EQP record, the EQP that works normally may be reading or reporting the FOUP ID when the handling completion record is read, and the goods arrival at EQP record is required to be acquired after a delay of a period of time. In the disclosure, the timing starting module 330 is arranged to perform the first timing, and when the duration of the first timing reaches the first preset time interval, the goods arrival at EQP record is acquired from the MES, thereby avoiding a false determination caused by untimely updating by the MES. It should be noted that the step of acquiring the handling completion record from the MES may be completed before the step of acquiring the goods arrival at EQP record, or may be executed at the same time with the step of acquiring the goods arrival at EQP record. No limits are made thereto in the embodiment.

In the embodiment, the timing starting module 330 is further configured to, when the comparison module 323 determines that the handling completion record does not correspond to the goods arrival at EQP record, trigger the second acquisition module 322 to retry to acquire the goods arrival at EQP record after a second preset time interval and trigger the comparison module 323 to compare the handling completion record and the acquired goods arrival at EQP record from a retry and determine whether the handling completion record corresponds to the acquired goods arrival at EQP record from a retry until a number of retries reaches a preset number of retries. The exception reporting module is further configured to, when a result of a last determination shows that the handling completion record does not correspond to the goods arrival at EQP record, generate the exception reporting information and send the exception reporting information to the monitoring platform.

Specifically, when the handling completion record does not correspond to the goods arrival at EQP record, a fault monitoring system determines the corresponding EQP that completes material handling but does not update a position or state of the material and the Load Port of the EQP, counts an "inconsistency" of the position or state of the material once, determines the count of the "inconsistency" as the number of retries, and determines whether the number of retries is less than the preset number of retries. If so, the second timing is performed, and when the duration of second timing reaches the second preset time interval, the step of acquiring the goods arrival at EQP record from the second submodule 312 of the storage module 310 of the MES is re-executed. Otherwise, the exception reporting information is generated and sent to the monitoring platform.

After determining the corresponding EQP that completes handling but does not update the state and the Load Port of the EQP, considering that the time for the EQP to read and report the FOUP ID is much less than an interval between two handling tasks, the "watchdog" may, after it is determined that the handling completion record does not correspond to the goods arrival at EQP record one by one, repeatedly acquire the goods arrival at EQP record from the MES at a second preset time interval to confirm whether the problem of no operation after goods arrival at EQP exists as soon as possible and, when determining that the problem of no operation after goods arrival at EQP exists, notify a staff to solve the problem timely. In addition, acquiring the goods arrival at EQP record from the MES only at the second preset time interval may reduce a transmitted data volume and accelerate a determination process.

Moreover, considering that, generally, a material handling period is long but the time of acquiring the goods arrival at EQP record and/or the handling completion record is short, the first time interval is usually much longer than the second time interval.

In the embodiment, a value of the second time interval ranges from 5 to 15 seconds. It should be understood that the value of the second time interval ranges from 5 to 15 seconds, so that the EQP has enough time to read and report the FOUP ID, a false determination caused by excessively short time and a relatively low reading speed of the EQP may be avoided. Furthermore, the problem of no operation after goods arrival at EQP cannot be found timely due to the excessively long time interval is also avoided. In the embodiment, the second time interval is preferably 8, 10, and 12 seconds.

In the embodiment, a value of the preset number of retries ranges from 3 to 8. It should be understood that the handling completion record is generated earlier than the goods arrival at EQP record, so the EQP that works normally may be in the process of reading or reporting the FOUP ID when the handling completion record is read. Thus it may not be determined whether there is no operation after goods arrival at EQP according to one comparison result to avoid a false determination. In the embodiment, the preset number of retries is preferably set to 4, 5, and 6.

In a non claimed embodiment, the exception reporting information is sent to the monitoring platform by a mail, a message, or a notification of an AMS to facilitate the staff at the monitoring platform to acquire the specific content of the exception reporting information and to quickly troubleshoot the fault. Furthermore, an alarming device may further be arranged at the monitoring platform, such as an alarm lamp flashes or an alarm horn beeping, to enable the staff at the monitoring platform to acquire the exception information timely. In a non claimed the embodiment, the exception reporting information may include the EQP ID, the Load Port ID, and the FOUP ID, and in addition, may further include FOUP handling completion time and current state information of the material.

The abovementioned embodiments only express some implementations of the disclosure, which are specifically described in detail, but they should not be understood as a limitation of the scope of the disclosure. It should be noted that the extent of the protection of the invention is solely defined by the scope of appended claims.

## Claims

1. A computer implemented method for monitoring a fault in a semiconductor manufacturing process, **characterized by** comprising:
acquiring (S110) a handling completion record and a goods arrival at Equipment, EQP, record from a Manufacturing Execution System, MES, wherein the handling completion record comprises at least an Identity document, ID, of a destination EQP and an ID of a handled material in a successful handling, and the goods arrival at EQP record comprises at least an ID of an EQP and an ID of a material read by the EQP;
determining (S120) whether the handling completion record corresponds to the goods arrival at EQP record by comparing the acquired handling completion record and goods arrival at EQP record; and
when the handling completion record does not correspond to the goods arrival at EQP record, generating (S130) exception reporting information and sending the exception reporting information to a monitoring platform;
wherein acquiring (S110) the handling completion record and the goods arrival at EQP record from the MES comprises:
receiving triggering information sent by the MES, the triggering information being generated by the MES after the MES receives the handling completion record;
acquiring the handling completion record from the MES according to the triggering information, and starting a first timing; and
when a duration of the first timing reaches a first preset time interval, acquiring the goods arrival at EQP record from the MES;
wherein when the handling completion record does not correspond to the goods arrival at EQP record, generating (S130) the exception reporting information and sending the exception reporting information to the monitoring platform comprises:
when the handling completion record does not correspond to the goods arrival at EQP record, retrying to acquire the goods arrival at EQP after a second preset time interval, and determining whether the handling completion record corresponds to the goods arrival at EQP record until a number of retries reaches a preset number of retries; and
when a result of a last determination according to said number of retries shows that the handling completion record does not correspond to the goods arrival at EQP record, generating the exception reporting information and sending the exception reporting information to the monitoring platform;
wherein a value of the second preset time interval ranges from 5 to 15 seconds; or
wherein a value of the preset number of retries ranges from 3 to 8;
wherein acquiring (S 110) the handling completion record and the goods arrival at EQP record from the MES further comprises:
acquiring the handling completion record from a first submodule of a storage module of the MES, and acquiring the goods arrival at EQP record from a second submodule of the storage module of the MES.

2. A system for monitoring a fault in a semiconductor manufacturing process, **characterized by** comprising:
a storage module (310), configured to store a handling completion record and a goods arrival at Equipment, EQP, record, wherein the handling completion record comprises at least an Identity document, ID, of a destination EQP and an ID of a handled material in a successful handling, and the goods arrival at EQP record comprises at least an ID of an EQP and an ID of a material read by the EQP;
a monitoring module (320), in communication connection with the storage module (310) and configured to acquire the handling completion record and the goods arrival at EQP record from a Manufacturing Execution System, MES, determine whether the handling completion record corresponds to the goods arrival at EQP record by comparing the acquired handling completion record and goods arrival at EQP record, and when the handling completion record does not correspond to the goods arrival at EQP record, generate exception reporting information and send the exception reporting information to a monitoring platform; and
a timing starting module (330), configured to receive triggering information sent by the MES, trigger, according to the triggering information, the first acquisition module (321) to acquire the handling completion record, start a first timing, and when a duration of the first timing reaches a first preset time interval, trigger the second acquisition module (322) to acquire the goods arrival at EQP record;
wherein:
the storage module (310) comprises:
a first submodule (311), configured to store the handling completion record; and
a second submodule (312), configured to store the goods arrival at EQP record;
the monitoring module (320) comprises:
a first acquisition module (321), configured to acquire the handling completion record from the first submodule (311);
a second acquisition module (322), configured to acquire the goods arrival at EQP record from the second submodule (312);
a comparison module (323), configured to determine whether the handling completion record corresponds to the goods arrival at EQP record by comparing the acquired handling completion record and goods arrival at EQP record; and
an exception reporting module (324), configured to, when the handling completion record does not correspond to the goods arrival at EQP record, generate the exception reporting information and send the exception reporting information to the monitoring platform;
the timing starting module (330) is further configured to, when the comparison module (323) determines that the handling completion record does not correspond to the goods arrival at EQP record, trigger the second acquisition module (322) to retry to acquire the goods arrival at EQP record after a second preset time interval, and trigger the comparison module (323) to compare the handling completion record and the acquired goods arrival at EQP record from a retry and determine whether the handling completion record corresponds to the acquired goods arrival at EQP record from the retry until a number of retries reaches a preset number of retries; and
the exception reporting module (324) is further configured to, when a result of a last determination according to said number of retries shows that the handling completion record does not correspond to the goods arrival at EQP record, generate the exception reporting information and send the exception reporting information to the monitoring platform;
wherein a value of the second preset time interval ranges from 5 to 15 seconds; or
wherein a value of the preset retry count ranges from 3 to 8.

## Patentansprüche

1. Computerimplementiertes Verfahren zum Überwachen eines Fehlers in einem Halbleiterherstellungsprozess, **dadurch gekennzeichnet, dass** es Folgendes umfasst:
Erfassen (S110) eines Bearbeitungsabschlussprotokolls und eines Protokolls über den Wareneingang an der Ausrüstung (EQP) von einem Herstellungsausführungssystem (MES), wobei das Bearbeitungsabschlussprotokoll mindestens ein Identitätsdokument (ID) einer Ziel-EQP und eine ID eines bearbeiteten Materials bei einer erfolgreichen Bearbeitung umfasst, und das Protokoll über den Wareneingang an der EQP mindestens eine ID einer EQP und eine ID eines von der EQP gelesenen Materials umfasst;
Bestimmen (S120), ob das Bearbeitungsabschlussprotokoll mit dem Protokoll über den Wareneingang an der EQP übereinstimmt, indem das erfasste Bearbeitungsabschlussprotokoll und das erfasste Protokoll über den Wareneingang an der EQP verglichen werden; und,
wenn das Bearbeitungsabschlussprotokoll nicht mit dem Protokoll über den Wareneingang an der EQP übereinstimmt, Erzeugen (S130) von Ausnahmeberichtsinformationen und Senden der Ausnahmeberichtsinformationen an eine Überwachungsplattform;
wobei das Erfassen (S110) des Bearbeitungsabschlussprotokolls und des Protokolls über den Wareneingang an der EQP vom MES Folgendes umfasst:
Empfangen von Auslöseinformationen, die vom MES gesendet werden, wobei die Auslöseinformationen vom MES erzeugt werden, nachdem das MES das Bearbeitungsabschlussprotokoll empfangen hat;
Erfassen des Bearbeitungsabschlussprotokolls vom MES gemäß den Auslöseinformationen und Starten einer ersten Zeitmessung; und,
wenn die Dauer der ersten Zeitmessung ein erstes voreingestelltes Zeitintervall erreicht, Erfassen des Protokolls über den Wareneingang an der EQP vom MES;
wobei, wenn das Bearbeitungsabschlussprotokoll nicht mit dem Protokoll über den Wareneingang an der EQP übereinstimmt, das Erzeugen (S130) von Ausnahmeberichtsinformationen und das Senden der Ausnahmeberichtsinformationen an die Überwachungsplattform Folgendes umfasst:
wenn das Bearbeitungsabschlussprotokoll nicht mit dem Protokoll über den Wareneingang an der EQP übereinstimmt, Wiederholen des Versuchs, den Wareneingang an der EQP nach einem zweiten voreingestellten Zeitintervall zu erfassen, und Bestimmen, ob das Bearbeitungsabschlussprotokoll mit dem Protokoll über den Wareneingang an der EQP übereinstimmt, bis eine Anzahl von Wiederholungen eine voreingestellte Anzahl von Wiederholungen erreicht; und,
wenn ein Ergebnis einer letzten Bestimmung gemäß der Anzahl der Wiederholungen zeigt, dass das Bearbeitungsabschlussprotokoll nicht mit dem Protokoll über den Wareneingang an der EQP übereinstimmt, Erzeugen der Ausnahmeberichtsinformationen und Senden der Ausnahmeberichtsinformationen an die Überwachungsplattform;
wobei ein Wert des zweiten voreingestellten Zeitintervalls zwischen 5 und 15 Sekunden liegt; oder
wobei ein Wert der voreingestellten Anzahl von Wiederholungsversuchen im Bereich von 3 bis 8 liegt;
wobei das Erfassen (S110) des Bearbeitungsabschlussprotokolls und des Protokolls über den Wareneingang an der EQP vom MES ferner Folgendes umfasst:
Erfassen des Bearbeitungsabschlussprotokolls von einem ersten Submodul eines Speichermoduls des MES und Erfassen des Protokolls über den Wareneingang an der EQP von einem zweiten Submodul des Speichermoduls des MES.

2. System zum Überwachen eines Fehlers in einem Halbleiterherstellungsprozess, **dadurch gekennzeichnet, dass** es Folgendes umfasst:
ein Speichermodul (310), das so konfiguriert ist, dass es ein Bearbeitungsabschlussprotokoll und ein Protokoll über den Wareneingang bei der Ausrüstung (EQP) speichert, wobei das Bearbeitungsabschlussprotokoll mindestens ein Identitätsdokument (ID) einer Ziel-EQP und eine ID eines bearbeiteten Materials bei einer erfolgreichen Bearbeitung umfasst, und das Protokoll über den Wareneingang bei der EQP mindestens eine ID einer EQP und eine ID eines von der EQP gelesenen Materials umfasst;
ein Überwachungsmodul (320), das in Kommunikationsverbindung mit dem Speichermodul (310) steht und so konfiguriert ist, dass es das Bearbeitungsabschlussprotokoll und das Protokoll über den Wareneingang an der EQP von einem Herstellungsausführungssystem (MES) erfasst, feststellt, ob das Bearbeitungsabschlussprotokoll mit dem Protokoll über den Wareneingang an der EQP übereinstimmt, indem es das erfasste Bearbeitungsabschlussprotokoll und das erfasste Protokoll über den Wareneingang an der EQP vergleicht, und, wenn das Bearbeitungsabschlussprotokoll nicht mit dem Protokoll über den Wareneingang an der EQP übereinstimmt, Ausnahmeberichtsinformationen erzeugt und die Ausnahmeberichtsinformationen an eine Überwachungsplattform sendet; und
ein Modul (330) zum Starten der Zeitmessung, das so konfiguriert ist, dass es vom MES gesendete Auslöseinformationen empfängt, das erste Erfassungsmodul (321) gemäß den Auslöseinformationen veranlasst, das Bearbeitungsabschlussprotokoll zu erfassen, eine erste Zeitmessung startet und, wenn eine Dauer der ersten Zeitmessung ein erstes voreingestelltes Zeitintervall erreicht, das zweite Erfassungsmodul (322) veranlasst, das Protokoll über den Wareneingang an der EQP zu erfassen;
wobei:
das Speichermodul (310) Folgendes umfasst:
ein erstes Submodul (311), das so konfiguriert ist, dass es das Bearbeitungsabschlussprotokoll speichert; und
ein zweites Submodul (312), das so konfiguriert ist, dass es das Protokoll über den Wareneingang an der EQP speichert;
das Überwachungsmodul (320) Folgendes umfasst:
ein erstes Erfassungsmodul (321), das so konfiguriert ist, dass es das Bearbeitungsabschlussprotokoll vom ersten Submodul (311) erfasst;
ein zweites Erfassungsmodul (322), das so konfiguriert ist, dass es das Protokoll über den Wareneingang an der EQP vom zweiten Submodul (312) erfasst;
ein Vergleichsmodul (323), das so konfiguriert ist, dass es durch Vergleichen des erfassten Bearbeitungsabschlussprotokoll und des erfassten Protokoll über den Wareneingang an der EQP feststellt, ob das Bearbeitungsabschlussprotokoll mit dem Protokoll über den Wareneingang an der EQP übereinstimmt; und
ein Ausnahmeberichtsmodul (324), das so konfiguriert ist, dass es, wenn das Bearbeitungsabschlussprotokoll nicht mit dem Protokoll über den Wareneingang an der EQP übereinstimmt, die Ausnahmemeldeinformationen erzeugt und die Ausnahmemeldeinformationen an die Überwachungsplattform sendet;
das Modul (330) zum Starten der Zeitmessung ferner so konfiguriert ist, dass es, wenn das Vergleichsmodul (323) feststellt, dass das Bearbeitungsabschlussprotokoll nicht mit dem Protokoll über den Wareneingang an der EQP übereinstimmt, das zweite Erfassungsmodul (322) veranlasst, den Versuch zu wiederholen, das Protokoll über den Wareneingang an der EQP nach einem zweiten voreingestellten Zeitintervall zu erfassen, und das Vergleichsmodul (323) veranlasst, das Bearbeitungsabschlussprotokoll und das bei einem wiederholten Versuch erfasste Protokoll über den Wareneingang an der EQP zu vergleichen und zu bestimmen, ob das Bearbeitungsabschlussprotokoll mit dem beim wiederholten Versuch erfassten Protokoll über den Wareneingang an der EQP übereinstimmt, bis eine Anzahl von Wiederholungen eine voreingestellte Anzahl von Wiederholungen erreicht; und
das Ausnahmemeldemodul (324) ferner so konfiguriert ist, dass es, wenn ein Ergebnis einer letzten Bestimmung gemäß der Anzahl der Wiederholungsversuche zeigt, dass das Bearbeitungsabschlussprotokoll nicht mit dem Protokoll über den Wareneingang an der EQP übereinstimmt, die Ausnahmemeldeinformationen erzeugt und die Ausnahmemeldeinformationen an die Überwachungsplattform sendet;
wobei ein Wert des zweiten voreingestellten Zeitintervalls zwischen 5 und 15 Sekunden liegt; oder
wobei ein Wert der voreingestellten Wiederholungszahl im Bereich von 3 bis 8 liegt.

## Revendications

1. Procédé informatisé de surveillance d'anomalies dans un processus de fabrication de semi-conducteurs, **caractérisé en ce qu'**il comprend :
l'acquisition (S110) d'un enregistrement de fin de manutention et d'un enregistrement d'arrivée de marchandises à l'équipement (EQP) à partir d'un système d'exécution de fabrication (MES), dans lequel l'enregistrement de fin de manutention comprend au moins un document d'identité (ID) d'un EQP de destination et un ID d'un matériau manipulé lors d'une manutention réussie, et l'enregistrement d'arrivée de marchandises à l'EQP comprend au moins un ID d'un EQP et un ID d'un matériau lu par l'EQP ;
la détermination (S120) de ce que l'enregistrement de fin de manutention correspond ou non à l'enregistrement d'arrivée de marchandises à l'EQP en comparant l'enregistrement de fin de manutention et l'enregistrement d'arrivée de marchandises à l'EQP acquis ; et
lorsque l'enregistrement de fin de manutention ne correspond pas à l'enregistrement d'arrivée de marchandises à l'EQP, la génération (S130) d'informations de rapport d'exception et l'envoi des informations de rapport d'exception à une plateforme de surveillance ;
dans lequel l'acquisition (S110) de l'enregistrement de fin de manutention et de l'enregistrement de l'arrivée de marchandises à l'EQP à partir du MES comprend :
la réception d'informations de déclenchement envoyées par le MES, les informations de déclenchement étant générées par le MES après réception de l'enregistrement de fin de manutention ;
l'acquisition de l'enregistrement de fin de manutention auprès du MES en fonction des informations de déclenchement, et le démarrage d'un premier chronométrage ; et
lorsque la durée du premier chronométrage atteint un premier intervalle de temps prédéfini, l'acquisition de l'enregistrement de l'arrivée de marchandises à l'EQP à partir du MES ;
dans lequel, lorsque l'enregistrement de fin de manutention ne correspond pas à l'enregistrement d'arrivée de marchandises à l'EQP, la génération (S130) des informations de rapport d'exception et l'envoi des informations de rapport d'exception à la plateforme de surveillance comprennent :
lorsque l'enregistrement de fin de manutention ne correspond pas à l'enregistrement d'arrivée de marchandises à l'EQP, une nouvelle tentative d'acquisition de l'arrivée de marchandises à l'EQP après un second intervalle de temps prédéfini, et la détermination de ce que l'enregistrement de fin de manutention correspond ou non à l'enregistrement d'arrivée de marchandises à l'EQP jusqu'à ce qu'un nombre de nouvelles tentatives atteigne un nombre prédéfini de nouvelles tentatives ; et
lorsqu'un résultat d'une dernière détermination en fonction dudit nombre de nouvelles tentatives montre que l'enregistrement de fin de manutention ne correspond pas à l'enregistrement d'arrivée de marchandises à l'EQP, la génération d'informations de rapport d'exception et l'envoi des informations de rapport d'exception à la plateforme de surveillance ;
dans lequel une valeur du second intervalle de temps prédéfini va de 5 à 15 secondes ; ou
dans lequel une valeur du nombre prédéfini de nouvelles tentatives va de 3 à 8 ;
dans lequel l'acquisition (S110) de l'enregistrement de fin de manutention et de l'enregistrement d'arrivée de marchandises à l'EQP à partir du MES comprend en outre :
l'acquisition de l'enregistrement de fin de manutention à partir d'un premier sous-module d'un module de stockage du MES, et l'acquisition de l'enregistrement d'arrivée de marchandises à l'EQP à partir d'un second sous-module du module de stockage du MES.

2. Système de surveillance d'anomalies dans un processus de fabrication de semi-conducteurs, **caractérisé en ce qu'**il comprend :
un module de stockage (310), configuré pour stocker un enregistrement de fin de manutention et un enregistrement d'arrivée de marchandises à l'équipement (EQP), dans lequel l'enregistrement de fin de manutention comprend au moins un document d'identité (ID) d'un EQP de destination et un ID d'un matériau manipulé lors d'une manutention réussie, et l'enregistrement d'arrivée de marchandises à l'EQP comprend au moins un ID d'un EQP et un ID d'un matériau lu par l'EQP ;
un module de surveillance (320), en connexion de communication avec le module de stockage (310) et configuré pour acquérir l'enregistrement de fin de manutention et l'enregistrement d'arrivée de marchandises à l'EQP à partir d'un système d'exécution de fabrication (MES), déterminer si l'enregistrement de fin de manutention correspond à l'enregistrement d'arrivée de marchandises à l'EQP en comparant l'enregistrement de fin de manutention et l'enregistrement d'arrivée de marchandises à l'EQP acquis, et lorsque l'enregistrement de fin de manutention ne correspond pas à l'enregistrement d'arrivée de marchandises à l'EQP, générer des informations de rapport d'exception et envoyer les informations de rapport d'exception à une plate-forme de surveillance ; et
un module de démarrage de chronométrage (330), configuré pour recevoir des informations de déclenchement envoyées par le MES, déclencher, en fonction des informations de déclenchement, le premier module d'acquisition (321) pour acquérir l'enregistrement de fin de manutention, démarrer un premier chronométrage et, lorsqu'une durée du premier chronométrage atteint un premier intervalle de temps prédéfini, déclencher le second module d'acquisition (322) pour acquérir l'enregistrement d'arrivée de marchandises à l'EQP ;
dans lequel :
le module de stockage (310) comprend :
un premier sous-module (311), configuré pour stocker l'enregistrement de fin de manutention ; et
un second sous-module (312), configuré pour stocker l'enregistrement d'arrivée de marchandises à l'EQP ;
le module de surveillance (320) comprend :
un premier module d'acquisition (321), configuré pour acquérir l'enregistrement de fin de manutention à partir du premier sous-module (311) ;
un second module d'acquisition (322), configuré pour acquérir l'enregistrement d'arrivée de marchandises à l'EQP à partir du second sous-module (312) ;
un module de comparaison (323), configuré pour déterminer si l'enregistrement de fin de manutention correspond ou non à l'enregistrement d'arrivée de marchandises à l'EQP en comparant l'enregistrement de fin de manutention et l'enregistrement d'arrivée de marchandises à l'EQP acquis ; et
un module de rapport d'exception (324), configuré pour, lorsque l'enregistrement de fin de manutention ne correspond pas à l'enregistrement d'arrivée de marchandises à l'EQP, générer les informations de rapport d'exception et envoyer les informations de rapport d'exception à la plate-forme de surveillance ;
le module de démarrage de chronométrage (330) est en outre configuré pour, lorsque le module de comparaison (323) détermine que l'enregistrement de fin de manutention ne correspond pas à l'enregistrement d'arrivée de marchandises à l'EQP, déclencher le second module d'acquisition (322) pour effectuer une nouvelle tentative d'acquisition de l'enregistrement d'arrivée de marchandises à l'EQP après un second intervalle de temps prédéfini, et déclencher le module de comparaison (323) pour comparer l'enregistrement de fin de manutention et l'enregistrement d'arrivée de marchandises à EQP acquis à partir d'une nouvelle tentative et déterminer si l'enregistrement de fin de manutention correspond à l'enregistrement d'arrivée de marchandises à l'EQP acquis à partir de la nouvelle tentative jusqu'à ce qu'un nombre de nouvelles tentatives atteigne un nombre prédéfini de nouvelles tentatives ; et
le module de rapport d'exception (324) est en outre configuré pour, lorsqu'un résultat d'une dernière détermination en fonction dudit nombre de nouvelles tentatives montre que l'enregistrement de fin de manutention ne correspond pas à l'enregistrement d'arrivée de marchandises à l'EQP, générer les informations de rapport d'exception et envoyer les informations de rapport d'exception à la plateforme de surveillance ;
dans lequel une valeur du second intervalle de temps prédéfini va de 5 à 15 secondes ; ou
dans lequel une valeur du nombre prédéfini de nouvelles tentatives va de 3 à 8.
